(19) Europäisches Patentamt
European Patent Office
Office européen des brevets

(11) **EP 3 534 164 B1**

(12) **EUROPEAN PATENT SPECIFICATION**

(45) Date of publication and mention of the grant of the patent:
**05.07.2023 Bulletin 2023/27**

(21) Application number: **18159754.3**

(22) Date of filing: **02.03.2018**

(51) International Patent Classification (IPC):
**G01R 27/32** $^{(2006.01)}$

(52) Cooperative Patent Classification (CPC):
**G01R 27/32**

(54) **SIGNAL INJECTION TECHNIQUE FOR MEASUREMENT AND CONTROL OF SOURCE REFLECTION COEFFICIENT AND FOR MEASUREMENT OF OUTPUT REFLECTION COEFFICIENT OF A DEVICE UNDER TEST**

SIGNALINJEKTIONSTECHNIK ZUR MESSUNG UND STEUERUNG DES QUELLENREFLEXIONSKOEFFIZIENTEN UND ZUR MESSUNG DES AUSGANGSREFLEXIONSKOEFFIZIENTEN EINER ZU TESTENDEN VORRICHTUNG

TECHNIQUE D'INJECTION DE SIGNAL POUR LA MESURE ET LE CONTRÔLE D'UN COEFFICIENT DE RÉFLEXION DE SOURCE ET POUR LA MESURE DU COEFFICIENT DE RÉFLEXION DE SORTIE D'UN DISPOSITIF SOUS TEST

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**04.09.2019 Bulletin 2019/36**

(73) Proprietor: **Anteverta-MW B.V.**
**5656 AE Eindhoven (NL)**

(72) Inventors:
• **Marchetti, Mauro**
**5656 AE Eindhoven (NL)**
• **Squillante, Michele**
**5656 AE Eindhoven (NL)**

(74) Representative: **Nederlandsch Octrooibureau**
**P.O. Box 29720**
**2502 LS The Hague (NL)**

(56) References cited:
**WO-A2-2007/081705     US-A1- 2006 161 409**
**US-A1- 2009 184 722**

• **JAN VERSPECHT ET AL: "Characterizing Components Under Large Signal Excitation: Defining Sensible "Large Signal S-Parameters"?!", ARFTG CONFERENCE DIGEST-SPRING, 19TH ARFTG, 1 June 1997 (1997-06-01), pages 109-117, XP055499460, Pi DOI: 10.1109/ARFTG.1997.327217 ISBN: 978-0-7803-5686-3**
• **DYLAN T BESPALKO ET AL: "X-parameter measurement challenges for unmatched device characterization", MICROWAVE MEASUREMENTS CONFERENCE (ARFTG), 2010 75TH ARFTG, IEEE, PISCATAWAY, NJ, USA, 28 May 2010 (2010-05-28), pages 1-4, XP031698221, ISBN: 978-1-4244-6364-0**
• **GOU YUANXIAO ET AL: "Analytical Reflection Coefficient Expressions Utilizing Load-Dependent $X$-Parameters", IEEE TRANSACTIONS ON MICROWAVE THEORY AND TECHNIQUES, PLENUM, USA, vol. 63, no. 10, 1 October 2015 (2015-10-01), pages 3142-3152, XP011670648, ISSN: 0018-9480, DOI: 10.1109/TMTT.2015.2470239 [retrieved on 2015-10-02]**

- GASSELING T ET AL: "A new characterization technique of Four hot S parameters for the study of nonlinear parametric behaviors of microwave devices", 2003 IEEE MTT-S INTERNATIONAL MICROWAVE SYMPOSIUM DIGEST.(IMS 2003). PHILADELPHIA, PA, JUNE 8 - 13, 2003; [IEEE MTT-S INTERNATIONAL MICROWAVE SYMPOSIUM], NEW YORK, NY : IEEE, US, 8 June 2003 (2003-06-08), page 1663, XP032412568, DOI: 10.1109/MWSYM.2003.1210458 ISBN: 978-0-7803-7695-3
- Csamii: "High Power Amplifi er Measurements Using Agilent's Nonlinear Vector Network Analyzer", , 26 January 2010 (2010-01-26), XP055499605, Retrieved from the Internet: URL:http://na.support.keysight.com/pna/nvna/NVNAWebHelp/NVNAHiPwrMeas.pdf
- MCKINLEY M D ET AL: "Linearization of Large-Signal Scattering Functions", IEEE TRANSACTIONS ON MICROWAVE THEORY AND TECHNIQUES, PLENUM, USA, vol. 53, no. 4, 1 April 2005 (2005-04-01), pages 1369-1376, XP011130523, ISSN: 0018-9480, DOI: 10.1109/TMTT.2005.845771
- ANDREA FERRERO ET AL: "Simple Technique for Source Reflection Coefficient Measurement While Characterizing Active Devices", ARFTG CONFERENCE DIGEST-SPRING, 19TH ARFTG, IEEE, PI, 1 June 1999 (1999-06-01), pages 1-3, XP031056113, ISBN: 978-0-7803-5686-3

## Description

### Field of the invention

The present invention relates to a method for measuring characteristic performance parameters of an active device under test (DUT) having an input port and an output port, such as a semiconductor active component in the form of a transistor, a FET, etc. In this document, characteristic performance parameters of the DUT are understood to be a source reflection coefficient $\Gamma_S$ or an output reflection coefficient $\Gamma_{OUT}$ of the DUT.

### Background art

US patent US 8,269,508 describes a method for calculating the performance of a transistor with any source impedance $\Gamma_S$. This method does not physically apply nor measure a different source impedance to the transistor, but it's a mathematical calculation done in a post-processing. Furthermore, the method as disclosed assumes that the transistor is perfectly unilateral ($S_{12} = 0$), which is rarely true.

US patent publication US2002/0196033 describes a method to measure the "hot-S22" of a DUT wherein the DUT is stimulated by a one-tone excitation signal at the input port, and the S22 under large-signal is measured by applying a probe tone at an offset frequency at its output.

US patent US 7,038,468 describes a method to measure all the DUT hot S-parameters by using probe tones at an offset frequency. Further relevant examples are described in "Characterizing Components Under Large Signal Excitation: Defining Sensible 'Large Signal S-Parameters'?!", JAN VERSPECHT ET AL, ARFTG CONFERENCE DIGEST-SPRING, 1 June 1997, pages 109-117, US 2006/161409 A1, US 2009/184722 A1, WO 2007/081705 A2, "Linearization of Large-Signal Scattering Functions", MCKINLEY M D ET AL, IEEE TRANSACTIONS ON MICROWAVE THEORY AND TECHNIQUES, PLENUM, USA, vol. 53, no. 4, 1 April 2005, pages 1369-1376 and "Simple Technique for Source Reflection Coefficient Measurement While Characterizing Active Devices", ANDREA FERRERO ET AL, ARFTG CONFERENCE DIGEST-SPRING, 19TH ARFTG, IEEE, June 1999, pages 1-3.

### Summary of the invention

The invention is defined by a method according to claim 1.

Further embodiments are defined by the corresponding dependent claims.

### Short description of drawings

The present invention will be discussed in more detail below, with reference to the attached drawings, in which:

Fig. 1 shows a schematic representation of a DUT having an input and output port in a measurement set-up according to an embodiment of the present invention;
Fig. 2 shows a schematic representation of a measurement system according to a further embodiment of the present invention;
Fig. 3 shows a schematic representation of a Thevenin equivalent circuit of a DUT;
Fig. 4A-C show graphical representations relating to exemplary measurements executed according to an embodiment of the present invention; and
Fig. 5A-E show graphical representations relating to further exemplary measurements executed according to an embodiment of the present invention.

### Description of embodiments

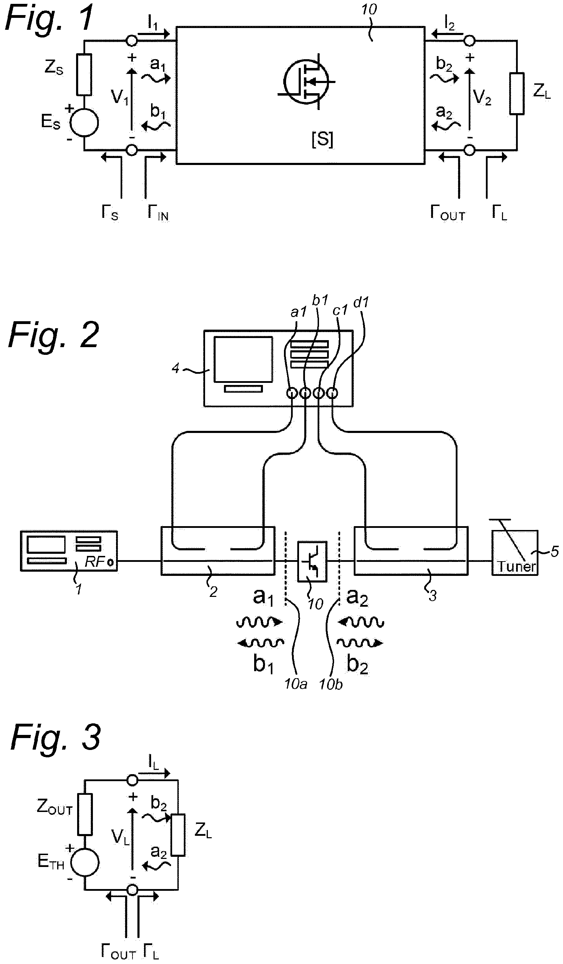

The present invention embodiments relate to a method for measuring characteristic performance parameters $\Gamma_S$; $\Gamma_{OUT}$ of an active device under test (DUT) 10 having an input port and an output port. The DUT 10 can be a semiconductor component such as a transistor or a Field Effect Transistor (FET). Fig. 1 show schematic representations of such a DUT having an input and output port, and Fig. 2 shows a typical measurement set-up according to an embodiment of the present invention.

The present invention method embodiments can be applied on any measurement system comprised of a signal generator 1 and two or more receivers 4 to measure $a_1$, $b_1$, $a_2$ and $b_2$ such as a Vector Network Analyzer (VNA) or a load-pull system. Fig. 2 shows a schematic representation of a measurement system, according to one embodiment of the present invention, which depicts a load-pull measurement system based on a four-channel receiver 4 (e.g. a VNA) and a generic load tuner 5. A signal generator 1 is connected to the DUT 10. The DUT 10 can be stimulated at any given frequency $f_1$ by the signal generator 1. The incident, reflected and scattered waves ($a_1$, $b_1$, $a_2$, $b_2$) are coupled with an input coupler 2 and an output coupler 3 and measured by a VNA 4. The output load impedance $Z_L$ can be tuned by use of any generic tuner 5, which can be either active or passive. Multiple tuners on the source or on the load can be used for controlling the reflection coefficient at one or more frequencies. Further, bias tees can be used for providing biasing voltages to the DUT 10. Various additional instruments, e.g. spectrum analysers, vector signal analysers or power meters can be used to perform additional measurements. In an alternative embodiment of the present invention, the signal generator 1, the input coupler 2, output coupler 3, and the receiver 4 can be integrated into a single measurement instrument like a VNA. The number of channels in the receiver 4 can vary as the measurements of $a_1$, $b_1$, $a_2$ and $b_2$ can be made in sequence. In such a case, a reference channel might be needed so that the waves $a_1$, $b_1$, $a_2$ and $b_2$ can be acquired in amplitude and/or phase.

The DUT 10 operational behaviour is described by a scattering matrix S relating an input incident wave $a_1$ and an input reflected wave $b_1$ at the input port of the DUT 10, and an output incident wave $a_2$ and an output reflected wave $b_2$ at the output port of the DUT 10. The method comprises connecting the input port of the DUT 10 to a signal generator 1 (see Fig. 2), and the output port to an output load impedance $Z_L$ (in Fig. 2 embodiment shown as a tuner 5). The method embodiments further comprise subjecting the DUT 10 to a large signal input test signal, and executing a first measurement $a_1'$, $b_1'$; $a_2'$, $b_2'$ of the incident wave $a_1$; $a_2$ and reflected wave $b_1$; $b_2$ at a respective DUT input and output reference planes 10a, 10b. The large signal input test signal is generated by a signal generator 1 and can have a fixed input power. The method further comprises subjecting the DUT 10 to a perturbation signal combined with the large signal input test signal, and executing a second measurement $a_1''$, $b_1''$; $a_2''$, $b_2''$ of the incident wave $a_1$; $a_2$ and reflected wave $b_1$; $b_2$ at the respective DUT input and output reference planes 10a, 10b. The method further comprises determining the characteristic performance parameter $\Gamma_S$; $\Gamma_{OUT}$ from the first measurement $a_1'$, $b_1'$; $a_2'$, $b_2'$ and the second measurement $a_1''$, $b_1''$; $a_2''$, $b_2''$. Thus, the present invention embodiments allows to for e.g. to control the source impedance (or source pull) on a DUT and/or to measure the output impedance of a DUT by means of a signal perturbation at the input or at the output of the DUT at any given frequency. As shown in Fig. 1, the signal generator 1 is equivalent to a voltage source $Es$ having a source impedance $Z_S$. The current at the input side is represented by $I_1$ and at the output side is represented by $I_2$. The voltage across the input terminals is represented by $V_1$ and between output terminals is represented by $V_2$. $\Gamma_S$ is the source impedance provided at the DUT input reference plane 10a and $\Gamma_L$ is the load reflection coefficient provided at the DUT output reference plane 10b.

In some embodiments of the present invention, the large signal input test signal is one of the group comprising: a continuous wave (CW) signal, a pulsed CW signal at a test frequency $f1$, a multi-tone signal, a modulated signal. The multi-tone signal can be comprised of multiple frequency components. Alternatively, the method described here can be applied at any or all the frequency components of the input signal. In a further embodiment of the present invention, the perturbation signal has a frequency corresponding to one or more frequency components of the large signal input test signal.

To control the source reflection coefficient to the DUT 10, the input test signal is perturbed during a test by adding a signal which can be controlled in amplitude and/or phase. In another embodiment of the present invention the perturbation signal comprises a perturbation of the amplitude of the large signal input test signal. In a further embodiment of the present invention, the perturbation signal comprises a perturbation of the phase of the large signal input test signal. By changing the amplitude and/or phase of the perturbation, the source reflection coefficient $\Gamma_S$ can be controlled, while $\Gamma_S$ can be measured at each perturbation by measuring the incident wave $a_1$ and the reflected wave $b_1$ with two subsequent measurements. The two subsequent measurements comprises the first measurement with the original test signal without applying any perturbation and the second measurement with applying the perturbation. Yet another embodiment of the present invention relates to subjecting the DUT 10 to a perturbation signal combined with the large signal input test signal that is obtained by controlling the signal generator 1.

In one embodiment of the present invention, the characteristic performance parameter is a source reflection coefficient $\Gamma_S$, and the DUT reference plane is at the input port of the DUT 10. The input and reflected waves $a_1$ and $b_1$ are linked to the wave $bs$ generated by the signal generator 1 and the source reflection coefficient $\Gamma_S$ can be related by the equation:

$$a_1 = bs + \Gamma_S \cdot b_1$$

According to this embodiment, the following steps can be used to measure and control $\Gamma_S$:
A first reference measurement of $a_1$ and $b_1$ is performed at a fixed input power, providing the following equation:

$$a_1' = bs_0 + \Gamma_{S0} \cdot b_1'$$

where $\Gamma_{S0}$ is the (passive) source reflection coefficient given by the source at the DUT reference plane. $\Gamma_{S0}$ is known a-priori either with a separate VNA measurement, or through a calibration measurement. The waves $a_1'$ and $b_1'$ are measured by the receiver 4. The parameter $bs_0$ is a source wave, which is not required to be known as demonstrated below.

In a second step, the source signal generated by signal generator 1 can be varied in a controlled, but arbitrary way, in amplitude and/or phase by adding an arbitrary wave $b_s'$ to the original source signal $b_{s0}$ so that $bs_1 = bs_0 + bs'$. This can be achieved by simply varying the power generated by the signal generator 1. Further, a new measurement of $a_1$ and $b_1$ is taken with the receiver 4 providing the following equations:

$$a_1'' = bs_1 + \Gamma_{S0} \cdot b_1''$$

$$a_1'' = bs_0 + bs' + \Gamma_{S0} \cdot b_1''$$

The wave $bs'$ is effectively changing only the source impedance, instead of changing the source power. As a result, the following equation applies: :

$$\Gamma_{S1} \cdot b_1'' = bs' + \Gamma_{S0} \cdot b_1''$$

where $\Gamma_{S1}$ is the effective new source impedance provided to the DUT.

Thus, the method of determining the characteristic performance parameter from the first measurement and the second measurement comprises measuring and controlling an effective source reflection coefficient $\Gamma_{S1}$ in accordance with the formula:

$$\Gamma_{S1} = \frac{a_1'' - a_1' + \Gamma_{S0} \cdot b_1'}{b_1''}$$

wherein $\Gamma_{S0}$ is a predetermined passive source reflection coefficient given by the source at the DUT reference plane. To further control $\Gamma_S$, the wave $bs'$ can be modified and a new equivalent $\Gamma_{S1}$ can be calculated.

In another embodiment of the present invention, the first measurement is executed at a fixed input power of the large signal input test signal. In a further embodiment of the present invention, the second measurement is executed with a perturbation of the fixed input power of the large signal input test signal. This can be obtained by simply varying the power of the signal generator 1.

A similar method can be used on the output side of the DUT 10 to measure the $\Gamma_{OUT}$ of the DUT 10, even under large signal behaviour. A small injection signal is applied at the output and by taking two measurements of the $b_2$ and $a_2$ wave (before and after the perturbation has been applied) the $\Gamma_{OUT}$ can be extracted. Thus, in another embodiment of the present invention, the characteristic performance parameter is an output reflection coefficient $\Gamma_{OUT}$, and the DUT reference plane is at the output port of the DUT. Fig. 3 shows a schematic representation of a Thévenin equivalent of a DUT 10 for this specific embodiment, from which the output reflected wave $b2$ can be represented by the equation:

$$b_2 = b_{TH} + \Gamma_{OUT} \cdot a_2$$

By applying a small perturbation in the output incident wave $a_2$ (which corresponds to having a slightly different load impedance $Z_L$), it is assumed that $\Gamma_{OUT}$ and $b_{TH}$ remain constant. The magnitude of the perturbation can be arbitrary and can be decided by the user. By performing two measurements, with and without applying a perturbation, the equations for output reflected wave $b2$ can be written as:

$$b_2' = b_{TH} + \Gamma_{OUT} \cdot a_2'$$

$$b_2'' = b_{TH} + \Gamma_{OUT} \cdot a_2''$$

Solving these two equations, $\Gamma_{OUT}$ can be calculated. Determining the characteristic performance parameter from the first measurement and the second measurement thus comprises calculating the output reflection coefficient $\Gamma_{OUT}$ in accordance with the formula:

$$\Gamma_{OUT} = \frac{b_2'' - b_2'}{a_2'' - a_2'}$$

The perturbation in $a_2$ or in $Z_L$ can be achieved in multiple ways. In a further embodiment of the present invention, subjecting the DUT 10 to a perturbation signal combined with the large signal input test signal comprises applying a passive load-pull arrangement to the output port of the DUT 10. Yet another embodiment of the present invention relates to an embodiment wherein subjecting the DUT 10 to a perturbation signal combined with the large signal input test signal comprises applying an active load-pull arrangement to the output port of the DUT. Both the passive or active load-pull change the impedance $Z_L$ to a small amount around the nominal value $Z_L$. In another embodiment of the present invention, subjecting the DUT to a perturbation signal combined with the large signal input test signal comprises changing the output load impedance $Z_L$.

An even further embodiment of the present invention relates to an embodiment wherein subjecting the DUT to a perturbation signal combined with the large signal input test signal comprises applying a second perturbation signal to the output port. The second perturbation signal can be with the same frequency or with the same frequencies as input test signal. Furthermore, it is possible to extract the value of $\Gamma_{OUT}$ from multiple measurement, for example by considering several load impedances in a circle around the nominal $Z_L$ value. In an embodiment of the present invention, calculating the output reflection coefficient $\Gamma_{OUT}$ comprises averaging results of multiple perturbation measurements. In such a case, $\Gamma_{OUT}$ is calculated as the average in all the perturbations.

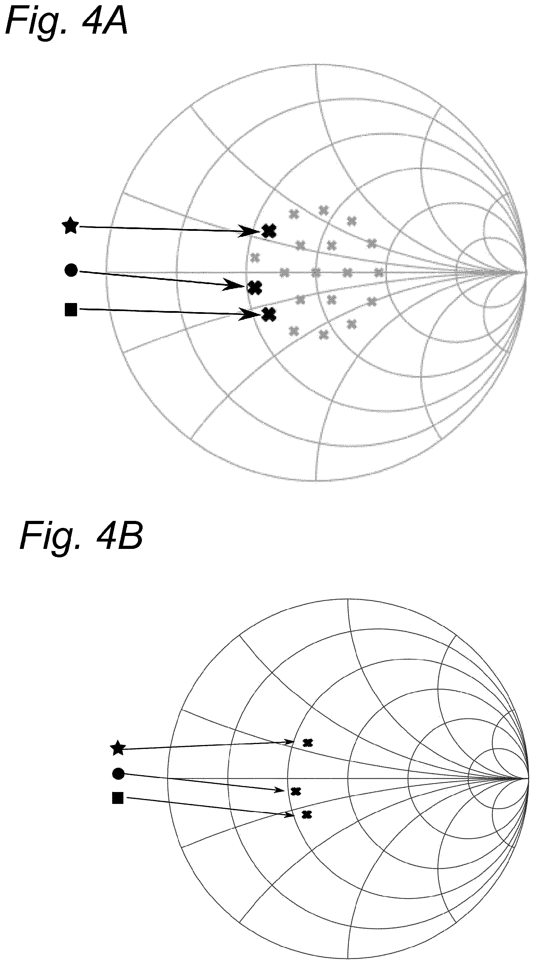

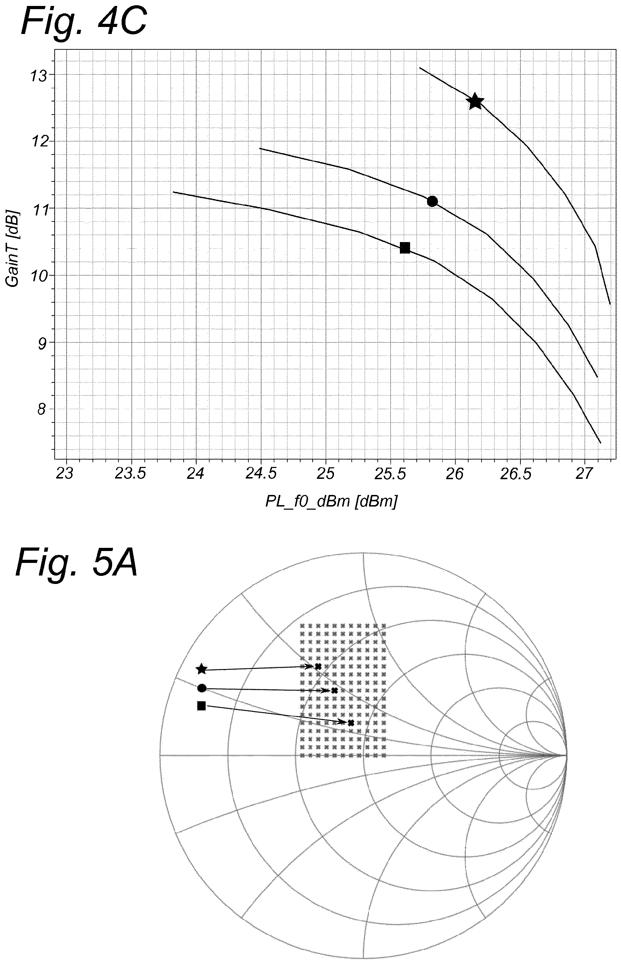

Fig. 4A-C show graphical representations related to measurements executed according to an embodiment of the present invention. In this embodiment, the method has been applied to measure and control the source reflection coefficient $\Gamma_S$ of a DUT 10, in this particular case an RF transistor. The setup used for the measurement and control of the source reflection coefficient is similar to the one depicted in Fig. 2, where a VNA 4 is used for measuring the $a_1$, $b_1$, $a_2$ and $b_2$ waves, and an arbitrary waveform generator 1 is used as signal source. By varying the power generated by the signal source (i.e. generator 1) and applying the method, a source pull sweep is performed and the transistor (DUT 10) performance is evaluated for several different source reflection coefficients $\Gamma_S$, Fig. 4A shows the user-defined source reflection coefficient that is applied to the DUT for three specific points on the Smith chart. Fig. 4B shows the source reflection coefficient $\Gamma_S$ measured with the present invention method at the input of the DUT 10. Fig. 4C shows a measurement of gain vs. output power for all the three different source reflection coefficients $\Gamma_S$ presented to the RF transistor as DUT 10. From this plot it can be seen how by changing the source reflection coefficient $\Gamma_S$ the Gain of the active device (DUT 10) is affected. The method can therefore be used to find the optimum source impedance matching to maximize some specific performance parameters of the active devices (DUT 10) such as transducer gain or third order intermodulation distortion.

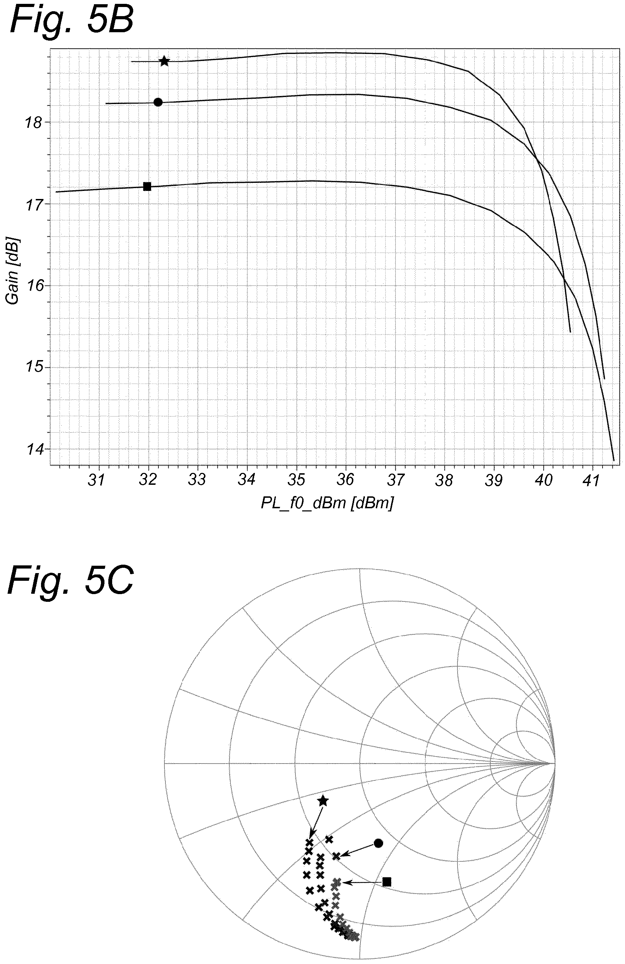

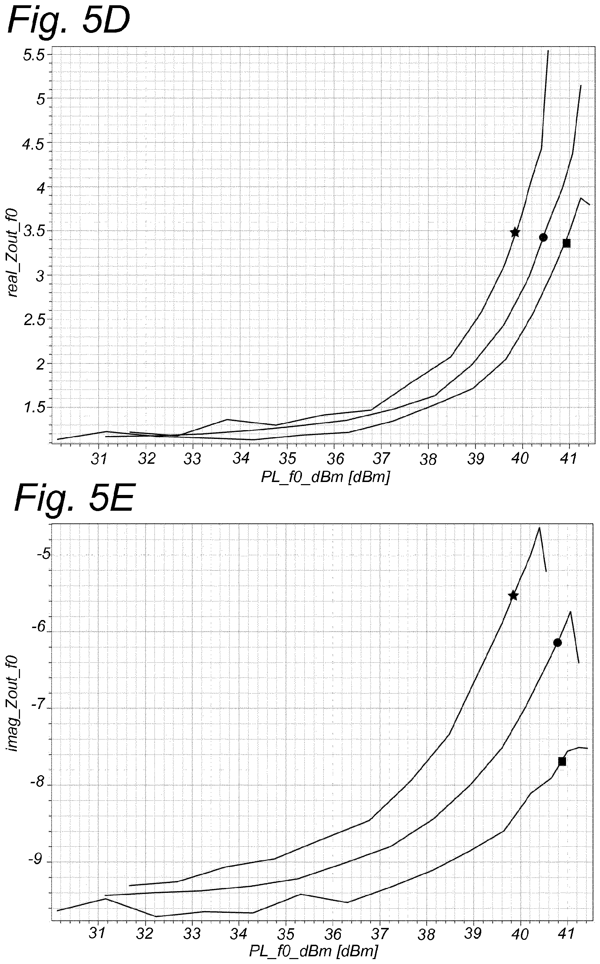

An example of a measurement where the technique has been applied to measure $\Gamma_{OUT}$ of an RF transistor as DUT 10 is shown in the graphical representations in Fig. 5A-E. This example shows measurement of an RF transistor where the input drive is swept and the load gamma $\Gamma_L$ to the transistor is swept as shown in Figure 5A on three distinct positions in the Smith chart. In this example active load-pull is used for varying the load reflection coefficient $\Gamma_{OUT}$ to the transistor (DUT 10), effectively perturbing the output signal. Fig. 5B shows the gain of the RF transistor for each of the three load $\Gamma_L$ vs. the output power. By using the method described by the present invention embodiments, the $\Gamma_{OUT}$ of the RF transistor is calculated for every value of $\Gamma_L$ presented to the RF transistor and for every power level. Fig. 5C shows the calculated $\Gamma_{OUT}$ as a function of power and for different $\Gamma_L$ plotted on a Smith Chart. Each group as indicated corresponds to a different $\Gamma_L$. Fig. 5D and Fig. 5E show the real and imaginary part of the output impedance $Z_{OUT}$ vs. the output power for all of the different $\Gamma_L$. As it can be seen the value of $\Gamma_{OUT}$ changes both as a function of power and as a function of the load reflection coefficient $\Gamma_L$. The ability to accurately measure the output reflection coefficient $\Gamma_{OUT}$ is extremely valuable for the extraction and the validation of accurate large signal models of the active transistor (DUT 10) for use in CAD circuit simulators. Another possible application is the design of power amplifiers where knowing the behaviour of $\Gamma_{OUT}$ can be used to find the transistor optimum output matching in some specific applications such as Doherty amplifier or oscillator design.

The present invention has been described above with reference to a number of exemplary embodiments as shown in the drawings. Modifications and alternative implementations of some parts or elements are possible, and are included in the scope of protection as defined in the appended claims.

**Claims**

1.  Method for measuring and controlling a characteristic performance parameter ($\Gamma_S$) of an active device under test, DUT, (10) having an input port, wherein the DUT operational behaviour is described by a scattering matrix S relating an input incident wave $a_1$ and an input reflected wave $b_1$ at the input port of the DUT (10),
the method comprising:

> connecting the input port of the DUT (10) to a signal generator (1),
> subjecting the DUT (10) to a large signal input test signal, and executing a first measurement ($a_1'$, $b_1'$) of the incident wave ($a_1$) and reflected wave ($b_1$) at a DUT input reference plane (10a) to determine
>
> $$bs_0 = a_1' - \Gamma_{S0} \cdot b_1'$$
>
> changing the input power to the DUT (10) by applying a new input wave $bs_1$, equivalent to the original input test signal $bs_0$ plus a perturbation signal $bs'$ such that $bs_1 = bs_0 + bs'$, executing a second measurement ($a_1''$, $b_1''$) of the incident wave ($a_1$) and reflected wave ($b_1$) at the DUT input reference plane (10a), and determining the newly applied characteristic performance parameter $\Gamma_{S1}$ from the first measurement ($a_1'$, $b_1'$) and the second measurement
>
> $$\Gamma_{S1} = \frac{a_1'' - a_1' + \Gamma_{S0} \cdot b_1'}{b_1''}$$
>
> ($a_1''$, $b_1''$) as
> wherein the characteristic performance parameter is a source reflection coefficient $\Gamma_S$, and
> wherein subjecting the DUT (10) to a perturbation signal combined with the input test signal is obtained by controlling the signal generator (1)

2.  Method according to claim 1, wherein the large signal input test signal is one of the group comprising: a CW signal, a pulsed CW signal at a test frequency $f_1$, a multi-tone signal, a modulated signal.

3.  Method according to claim 1 or 2, wherein the perturbation signal has a frequency corresponding to one or more frequency components of the large signal input test signal.

4.  Method according to any one of claims 1-3, wherein the perturbation signal comprises a perturbation of the amplitude of the large signal input test signal.

5.  Method according to any one of claims 1-4, wherein the perturbation signal comprises a perturbation of the phase of the large signal input test signal.

6.  Method according to any one of claims 1-5, wherein the DUT input reference plane is at the input port of the DUT (10),

> and wherein determining the characteristic performance parameter from the first measurement

($a_1'$, $b_1'$) and the second measurement ($a_1''$,$b_1''$) comprises

measuring and controlling an effective source reflection coefficient $\Gamma_{S1}$ in accordance with the formula:

$$\Gamma_{S1} = \frac{a_1'' - a_1' + \Gamma_{S0} \cdot b_1'}{b_1''}$$

wherein $\Gamma_{S0}$ is a predetermined passive source reflection coefficient given by the source at the DUT input reference plane.

**7.** Method according to claim 6, wherein the first measurement ($a_1'$,$b_1'$) is executed at a fixed input power of the large signal input test signal.

**8.** Method according to claim 6 or 7, wherein the second measurement ($a_1''$,$b_1''$) is executed with a perturbation of the fixed input power of the large signal input input test signal.

**Patentansprüche**

**1.** Verfahren zum Messen und Steuern eines charakteristischen Leistungsparameters ($\Gamma_s$) einer zu prüfenden aktiven Vorrichtung, device under test - DUT, (10) mit einem Eingangsport, wobei das Betriebsverhalten des DUT durch eine Streumatrix S beschrieben wird, die eine einfallende Eingangswelle $a_1$ und eine reflektierte Eingangswelle $b_1$ am Eingangsport des DUT (10) in Beziehung setzt, wobei das Verfahren umfasst:

Verbinden des Eingangsports des DUT (10) mit einem Signalgenerator (1),
Aussetzen des DUT (10) einem Großsignal-Eingangstestsignal, und Ausführen einer ersten Messung ($a_1'$,$b_1'$) der einfallenden Welle ($a_1$) und der reflektierten Welle ($b_1$) an einer DUT-Eingangsreferenzebene (10a), um $bs_0 = a_1'$ - $\Gamma_{S0} \cdot b_1'$ zu bestimmen,
Ändern der Eingangsleistung in das DUT (10) durch Anlegen einer neuen Eingangswelle $bs_1$, die dem ursprünglichen Eingangstestsignal $bs_0$ plus einem Störsignal $bs'$ entspricht, so dass $bs_1 = bs_0 + bs'$ ist,
Ausführen einer zweiten Messung ($a_1''$, $b_1''$) der einfallenden Welle ($a_1$) und der reflektierten Welle ($b_1$) an der DUT-Eingangsreferenzebene (10a), und

Bestimmen des neu angelegten charakteristischen Leistungsparameters ($\Gamma_{S1}$) aus der ersten

Messung ($a_1'$, $b_1'$) und der zweiten Messung

$$\Gamma_{S1} = \frac{a_1'' - a_1' + \Gamma_{S0} \cdot b_1'}{b_1''}$$

($a_1''$, $b_1''$) als          , wobei der charakteristische Leistungsparameter ein Quellenreflexionskoeffizient $\Gamma_s$ ist, und
wobei das Aussetzen des DUT (10) einem mit dem Eingangstestsignal kombinierten Störsignal durch Steuern des Signalgenerators (1) erhalten wird.

**2.** Verfahren nach Anspruch 1, wobei das Großsignal-Eingangstestsignal eines aus der Gruppe ist, die Folgendes umfasst:
ein CW-Signal, ein gepulstes CW-Signal mit einer Testfrequenz $f_1$, ein Mehrtonsignal, ein moduliertes Signal.

**3.** Verfahren nach Anspruch 1 oder 2, wobei das Störsignal eine Frequenz hat, die einer oder mehreren Frequenzkomponenten des Großsignal-Eingangstestsignals entspricht.

**4.** Verfahren nach einem der Ansprüche 1 bis 3, wobei das Störsignal eine Störung der Amplitude des Großsignal-Eingangstestsignals umfasst.

**5.** Verfahren nach einem der Ansprüche 1 bis 4, wobei das Störungssignal eine Störung der Phase des Großsignal-Eingangstestsignals umfasst.

**6.** Verfahren nach einem der Ansprüche 1-5, wobei sich die DUT-Referenzebene am Eingangsport des DUT (10) befindet, und
wobei das Bestimmen des charakteristischen Leistungsparameters aus der ersten Messung ($a_1'$, $b_1'$) und der zweiten Messung ($a_1''$, $b_1''$) das Messen und Steuern eines effektiven Quellenreflexionskoeffizienten $\Gamma_{s1}$ gemäß der Formel:

$$\Gamma_{S1} = \frac{a_1'' - a_1' + \Gamma_{S0} \cdot b_1'}{b_1''}$$

umfasst, wobei $\Gamma_{s0}$ ein vorbestimmter passiver Quellenreflexionskoeffizient ist, der durch die Quelle an der DUT-Eingangsreferenzebene gegeben ist.

**7.** Verfahren nach Anspruch 6, wobei die erste Messung ($a_1'$, $b_1'$) bei einer festen Eingangsleistung des Großsignal-Eingangstestsignals ausgeführt wird.

**8.** Verfahren nach Anspruch 6 oder 7, wobei die zweite Messung ($a_1''$, $b_1''$) mit einer Störung der festen Eingangsleistung des Großsignal-Eingangstestsignals ausgeführt wird.

**Revendications**

1. Procédé de mesure et de commande d'un paramètre de performance caractéristique ($\Gamma_S$) d'un dispositif actif sous test, DUT, (10) présentant un port d'entrée, dans lequel le comportement de fonctionnement de DUT est décrit par une matrice de diffusion S mettant en relation une onde incidente d'entrée $a_1$ et une onde réfléchie d'entrée $b_1$ au niveau du port d'entrée du DUT (10),
le procédé comprenant les étapes consistant à :

   connecter le port d'entrée du DUT (10) à un générateur de signal (1),
   soumettre le DUT (10) à un signal de test d'entrée de signal important, et exécuter une première mesure ($a_1'$, $b_1'$) de l'onde incidente ($a_1$) et de l'onde réfléchie ($b_1$) au niveau d'un plan de référence d'entrée de DUT (10a) pour déterminer

$$bs_0 = a_1' - \Gamma_{S0} \cdot b_1'$$

   changer la puissance d'entrée vers le DUT (10) en appliquant une nouvelle onde d'entrée $bs_1$, équivalente au signal de test d'entrée d'origine $bs_0$ plus un signal de perturbation $bs'$ de telle sorte que $bs_1 = bs_0 + bs'$,
   exécuter une seconde mesure ($a_1''$, $b_1''$) de l'onde incidente ($a_1$) et de l'onde réfléchie ($b_1$) au niveau du plan de référence d'entrée de DUT (10a), et
   déterminer le paramètre de performance caractéristique $\Gamma_{S1}$ nouvellement appliqué à partir de la première mesure ($a1'$, $b1'$) et de la seconde mesure ($a1''$, $b1''$) sous la forme

$$\Gamma_{S1} = \frac{a_1'' - a_1' + \Gamma_{S0} \cdot b_1'}{b_1''},$$

   dans lequel le paramètre de performance caractéristique est un coefficient de réflexion de source $\Gamma_S$, et dans lequel le fait de soumettre le DUT (10) à un signal de perturbation combiné au signal de test d'entrée est obtenu en commandant le générateur de signal (1).

2. Procédé selon la revendication 1, dans lequel le signal de test d'entrée de signal important est un signal du groupe comprenant :
un signal CW, un signal CW pulsé à une fréquence de test $f_1$, un signal à plusieurs tonalités, un signal modulé.

3. Procédé selon la revendication 1 ou 2, dans lequel le signal de perturbation présente une fréquence correspondant à une ou plusieurs composantes de fréquence du signal de test d'entrée de signal important.

4. Procédé selon l'une quelconque des revendications 1 à 3, dans lequel le signal de perturbation comprend une perturbation de l'amplitude du signal de test d'entrée de signal important.

5. Procédé selon l'une quelconque des revendications 1 à 4, dans lequel le signal de perturbation comprend une perturbation de la phase du signal de test d'entrée de signal important.

6. Procédé selon l'une quelconque des revendications 1 à 5, dans lequel le plan de référence d'entrée de DUT est au niveau du port d'entrée du DUT (10), et dans lequel la détermination du paramètre de performance caractéristique à partir de la première mesure ($a_1'$, $b_1'$) et de la seconde mesure ($a_1''$, $b_1''$) comprend la mesure et la commande d'un coefficient de réflexion de source efficace $\Gamma_{S1}$ selon la formule :

$$\Gamma_{S1} = \frac{a_1'' - a_1' + \Gamma_{S0} \cdot b_1'}{b_1''},$$

   dans laquelle $\Gamma_{S0}$ est un coefficient de réflexion de source passif prédéterminé donné par la source au niveau du plan de référence d'entrée de DUT.

7. Procédé selon la revendication 6, dans lequel la première mesure ($a_1'$, $b_1'$) est exécutée à une puissance d'entrée fixe du signal de test d'entrée de signal important.

8. Procédé selon la revendication 6 ou 7, dans lequel la seconde mesure ($a_1''$, $b_1''$) est exécutée avec une perturbation de la puissance d'entrée fixe du signal de test d'entrée de signal important.

Fig. 1

Fig. 2

Fig. 3

## Fig. 4A

## Fig. 4B

## Fig. 4C

## Fig. 5A

## Fig. 5B

## Fig. 5C

## Fig. 5D

## Fig. 5E

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 8269508 B
- US 20020196033 A
- US 7038468 B
- US 2006161409 A1
- US 2009184722 A1
- WO 2007081705 A2

**Non-patent literature cited in the description**

- **JAN VERSPECHT et al.** Characterizing Components Under Large Signal Excitation: Defining Sensible 'Large Signal S-Parameters'?!. *ARFTG CONFERENCE DIGEST-SPRING,* 01 June 1997, 109-117
- Linearization of Large-Signal Scattering Functions. **MCKINLEY M D et al.** IEEE TRANSACTIONS ON MICROWAVE THEORY AND TECHNIQUES. PLENUM, 01 April 2005, vol. 53, 1369-1376
- Simple Technique for Source Reflection Coefficient Measurement While Characterizing Active Devices. **ANDREA FERRERO et al.** ARFTG CONFERENCE DIGEST-SPRING, 19TH ARFTG. IEEE, June 1999, 1-3